# EUROPÄISCHE PATENTSCHRIFT

(11) **EP 3 703 242 B1**
(45) Veröffentlichungstag und Bekanntmachung des Hinweises auf die Patenterteilung: **26.04.2023**
(21) Anmeldenummer: 19160214.3
(22) Anmeldetag: 01.03.2019
(51) Int. Cl.: H02P 1/16

(54) **SCHALTVORRICHTUNG FÜR EINEN EIN- ODER MEHRPHASIGEN ELEKTRISCHEN VERBRAUCHER**
SWITCHING DEVICE FOR A SINGLE OR MULTIPHASE ELECTRIC CONSUMER
DISPOSITIF DE COMMUTATION POUR UN CONSOMMATEUR ÉLECTRIQUE MONOPHASE OU MULTIPHASE

(43) Veröffentlichungstag der Anmeldung: 02.09.2020
(73) Patentinhaber: Siemens Aktiengesellschaft, 80333 München (DE)
(72) Erfinder: Engelmann, Johannes, 92224 Amberg (DE); Käsbauer, Peter, 92421 Schwandorf (DE)
(74) Vertreter: Siemens Patent Attorneys

(56) Entgegenhaltungen:
- EP-A2- 1 037 515
- US-A- 4 943 890
- US-A- 5 337 214

## Beschreibung

Die Erfindung betrifft eine Schaltvorrichtung für einen ein- oder mehrphasigen elektrischen Verbraucher. Die Schaltvorrichtung umfasst eine der Anzahl der Phasen entsprechende Anzahl an Leitungssträngen, wobei jeder Leitungsstrang ein als Eingang dienendes erstes Anschlussteil zur Verbindung mit einer Netzphase und ein als Ausgang dienendes zweites Anschlussteil zur Verbindung mit einer Phase des elektrischen Verbrauchers umfasst. Die Schaltvorrichtung umfasst ferner ein Leistungsmodul und eine Überbrückungseinheit. Das Leistungsmodul umfasst pro Phase zumindest ein steuerbares Halbleiterschaltelement, wobei das zumindest eine steuerbare Halbleiterschaltelement zwischen dem ersten und dem zweiten Anschlussteil verschaltet ist. Die Überbrückungseinheit umfasst pro Phase ein steuerbares elektromechanisches Schaltelement mit geringem Durchlasswiderstand, wobei das steuerbare elektromechanische Schaltelement, parallel zu dem zumindest einen steuerbaren Halbleiterschaltelement dieser Phase, zwischen dem ersten und dem zweiten Anschlussteil verschaltet ist.

Eine derartige Schaltvorrichtung ist beispielsweise ein Sanftstarter für eine Arbeitsmaschine, insbesondere eine permanent erregte Drehstrommaschine. Das Leistungsmodul wird benötigt, um die Arbeitsmaschine gesteuert anlaufen zu lassen. Die Überbrückungseinheit dient dazu, die Verlustleistung beim Betrieb im Nennbetriebspunkt der Arbeitsmaschine möglichst gering zu halten. Die Minimierung der Verlustleistung wird dadurch realisiert, dass das Leistungsmodul nach Erreichen des Nennbetriebspunkts mit Hilfe der Überbrückungseinheit und den darin enthaltenen elektromechanischen Schaltelementen, überbrückt wird. Bei einem Sanftstarter wird die Überbrückungseinheit auch als "Bypass" bezeichnet, wobei die steuerbaren elektromechanischen Schaltelemente in Gestalt von Schützen oder Relais vorliegen. Die Überbrückungseinheit kann zusammen mit dem Leistungsmodul in einem gemeinsamen Gehäuse angeordnet sein. Es sind auch solche Sanftstarter bekannt, bei denen die Überbrückungseinheit und das Leistungsmodul in unterschiedlichen Gehäusen vorliegen und am Einsatzort durch entsprechende Verschaltung zu dem Sanftstarter kombiniert werden.

Ein Nachteil einer derartigen Schaltvorrichtung ist es, dass durch die Verwendung der fertigen Teilkomponenten ein Aufbau nicht kompakt, d.h. mit geringen äußeren Abmaßen, realisiert werden kann. Hinzu kommt, dass insbesondere dann, wenn die Überbrückungseinheit und das Leistungsmodul in unterschiedlichen Gehäusen vorliegen, diese mit hohem Aufwand elektrisch miteinander verbunden werden müssen. Dieser Verdrahtungsaufwand kann sich negativ auf die im Betrieb entstehende Verlustwärme auswirken. In jedem Fall sind durch die aufwändigen Fertigungsschritte hohe Herstellkosten damit verbunden.

EP 1 037 515 A2 (Eaton Corp.) 20.09.2000 beschreibt einen Halbleiter-Motorstarter mit einem linearen Strompfad von einem Eingangsende (36) zu einem Ausgangsende (44) des Motorstarters. Dabei ist ein Lüfterelement (66), welches zur Kühlung Luft an einem Kühlkörper (64) entlang fördert, zwischen einem Bypass (50) und dem Kühlkörper (64) an einem Gehäusedeckel (12) des Motorstarters befestigt.

US 4 943 890 A (Schaltenbrand, Robert W. et al.) 24.07.1990 beschreibt einen Motorstarter mit Halbleiter-Leistungsmodulen (3a, 3b) und einem Bypass (4a, 4b, 5), wobei die Stromanschlüsse (10, 10b) des Motorstarters auf einer gemeinsamen Seite des Motorstarters angeordnet sind.

US 5 337 214 A (Lindsey, Kurt L. et al.) 09.08.1994 beschreibt einen Motorstarter mit Halbleiter-Leistungsmodulen (12, 14) und mindestens einem Bypass (30, 30'), wobei die Stromanschlüsse (26) des Motorstarters auf einer gemeinsamen Seite des Motorstarters angeordnet sind.

Es ist wünschenswert, eine Schaltvorrichtung der oben genannten Art bereitzustellen, welche durch konstruktive Maßnahmen einen geringen Verdrahtungsaufwand zwischen Leistungsmodul und Überbrückungseinheit nach sich zieht und gleichzeitig mit minimalen äußeren Abmaßen bereitgestellt werden kann.

Diese Aufgabe wird gelöst durch eine Schaltvorrichtung gemäß den Merkmalen des Anspruchs 1. Vorteilhafte Ausgestaltungen ergeben sich aus den abhängigen Ansprüchen.

Es wird eine Schaltvorrichtung für einen ein- oder mehrphasigen elektrischen Verbraucher vorgeschlagen. Die Schaltvorrichtung umfasst eine der Anzahl der Phasen entsprechende Anzahl an Leitungssträngen, wobei jeder Leitungsstrang ein als Eingang dienendes erstes Anschlussteil zur Verbindung mit einer Netzphase und ein als Ausgang dienendes zweites Anschlussteil zur Verbindung mit einer Anschlussphase des elektrischen Verbrauchers umfasst. Die Schaltvorrichtung umfasst ferner ein Leistungsmodul, das pro Phase zumindest ein steuerbares Halbleiterschaltelement umfasst, wobei das zumindest steuerbare Halbleiterschaltelement zwischen dem ersten und dem zweiten Anschlussteil verschaltet ist. Ferner umfasst die Schaltvorrichtung eine Überbrückungseinheit, die pro Phase ein steuerbares elektromechanisches Schaltelement mit geringem Durchlasswiderstand umfasst. Das steuerbare elektromechanische Schaltelement ist dabei, parallel zu dem zumindest einen steuerbaren Halbleiterschaltelement dieser Phase, zwischen dem ersten und dem zweiten Anschlussteil verschaltet.

Die Schaltvorrichtung zeichnet sich dadurch aus, dass das erste und das zweite Anschlussteil einer jeweiligen Phase an einer Seite des Leistungsmoduls in räumlicher Nähe in einer Erstreckungsrichtung benachbart nebeneinander angeordnet sind. Ferner verläuft eine Kontaktbrücke des einer jeweiligen Phase zugeordneten elektromechanischen Schaltelements der Überbrückungseinheit in der Erstreckungsrichtung, um im angeschalteten Zustand des steuerbaren elektromechanischen Schaltelements das erste und das zweite Anschlussteil elektrisch zu verbinden.

Die erfindungsgemäße Schaltvorrichtung ermöglicht einen kompakten und kostengünstigen Aufbau, indem das erste und das zweite Anschlussteil, an denen jeweilige Lastanschlüsse der Schaltelemente des Leistungsmoduls und der Überbrückungseinheit angeschlossen sind, auf einer Seite des Leistungsmoduls und in räumliche Nähe zueinander angeordnet werden. Dies ermöglicht es, das erste und das zweite Anschlussteil einer Phase nach dem Erreichen des Nennbetriebspunkts mittels einer Kontaktbrücke, die Teil des steuerbaren elektromechanischen Schaltelements einer Phase der Überbrückungseinheit ist, zu verbinden. Durch die in Erstreckungsrichtung verlaufende Kontaktbrücke können die Komponenten des Leistungsmoduls sehr einfach zu- oder weggeschaltet werden. Insbesondere ermöglicht es dieser Aufbau, den Verdrahtungsaufwand zwischen den Komponenten des Leistungsmoduls und der Überbrückungseinheit zu minimieren. Konstruktives Merkmal dieser Schaltvorrichtung ist es somit, dass sich die Ein- und Ausgänge der Schaltvorrichtung an einer Seite des Geräts befinden.

Durch die Überbrückung des als Eingang dienenden ersten Anschlussteils und des als Ausgang dienenden zweiten Anschlussteils mittels der Kontaktbrücke können Stromwege verkürzt werden. Dies ermöglicht es, die Schaltvorrichtung kompakt aufzubauen. Insbesondere kann eine Verbindung zu der Überbrückungseinheit entfallen.

Die Reduzierung der Stromwege und die Reduzierung der Kontaktstellen weisen darüber hinaus einen positiven Effekt auf die Verlustwärme und damit die Robustheit der Schaltvorrichtung auf.

Eine zweckmäßige Ausgestaltung sieht vor, dass das Leistungsmodul und die Überbrückungseinheit in einem gemeinsamen Gehäuse angeordnet sind. Dies erleichtert die Handhabung der Schaltvorrichtung bei der Installation an einem Einsatzort, da lediglich die Schaltvorrichtung, z.B. an einer Leiterschiene befestigt werden braucht und die Netz- und die Anschlussphase mit den entsprechenden Leitungen verbunden werden müssen. Die Vornahme interner Verdrahtungen ist hierbei nicht erforderlich. Diese Ausgestaltung begünstigt einen kompakten Aufbau.

Eine weitere Ausgestaltung sieht vor, dass das Leistungsmodul und die Überbrückungseinheit einer jeweiligen Phase in einer Anordnungsrichtung hintereinander angeordnet sind, wobei die Anordnungsrichtung quer zu der Erstreckungsrichtung verläuft. Dies ermöglicht einen schlanken Aufbau der Schaltvorrichtung, d.h. bei einer üblichen Befestigung an einer Leiterschiene weist die Schaltvorrichtung eine geringe Breite auf. Dadurch, dass das erste und das zweite Anschlussteil an einer Seite des Leistungsmoduls angeordnet sind und aus dem Gehäuse der Schaltvorrichtung herausgeführt werden können, kann der in der Höhe benötigte Platz zum Herstellen der Verbindung zur Netzphase und der Anschlussphase gering gehalten werden.

Das Leistungsmodul und die Überbrückungseinheit einer jeweiligen Phase sind gemäß einer weiteren zweckmäßigen Ausgestaltung seitlich von in der Anordnungsrichtung verlaufenden Trennwänden begrenzt. Hierdurch ergibt sich einerseits eine Isolation der zu einer Phase zugehörigen Komponenten. Darüber hinaus kann andererseits die Entwärmung vereinfacht werden.

Eine weitere Ausgestaltung sieht vor, dass das erste und das zweite Anschlussteil flächige Abschnitte von Anschlussschienen sind, deren Enden flächige Endabschnitte zur Verbindung mit Anschlusselementen der Netzphase bzw. Anschlussphase des Verbrauchers umfassen. Dadurch, dass das erste und das zweite Anschlussteil flächige Abschnitte von Anschlussschienen sind, können diese auf besonders einfache Weise mit Kontakten der Kontaktbrücke in elektrischen Kontakt gebracht werden, um im eingeschalteten Zustand des steuerbaren elektromechanischen Schaltelements der Überbrückungseinheit das erste und das zweite Anschlussteil elektrisch zu verbinden. Auf diese Weise lässt sich somit eine konstruktiv einfache Verbindung realisieren, wobei die Anschlusselemente Teil des Kontaktweges der Überbrückungseinheit darstellen.

Es ist vorgesehen, dass die Schaltvorrichtung pro Phase ein Lüfterelement umfasst. In Verbindung mit den Trennwänden zwischen den Komponenten benachbart angeordneter Phasen kann ein gezielter Luftstrom in Richtung der sich im Betrieb erwärmenden Komponenten des Leistungsmoduls und der Überbrückungseinheit geführt werden. Hierdurch kann die in den Komponenten entstehende Wärme über die Luft abgeführt werden.

Es ist weiterhin vorgesehen, dass das Lüfterelement an den, zu einer Phase gehörenden, Anschlussschienen mechanisch befestigt ist. Das Lüfterelement kann z.B. auf besonders einfache Weise durch eine lösbare Steckverbindung an den Anschlussschienen oder einem daran angebrachten Befestigungsteil angebracht werden. Insbesondere ist es nicht erforderlich, für das Lüfterelement an dem Gehäuse oder einem Gehäuseteil entsprechende integrale Komponenten vorzusehen.

Es ist weiterhin zweckmäßig, wenn das Lüfterelement und die Überbrückungseinheit auf gegenüberliegenden Seiten der, zu einer Phase gehörenden, Anschlussschienen angeordnet sind. Dies ermöglicht einen kompakten Aufbau der Schaltvorrichtung.

Eine weitere zweckmäßige Ausgestaltung sieht vor, dass ein von dem Lüfterelement erzeugbarer Luftstrom in der Anordnungsrichtung einen mit dem Leistungsmodul wärmeleitend verbundenen Kühlkörper anströmt. Dadurch, dass der Kühlkörper direkt in der Anordnungsrichtung des Luftstroms liegt, kann die an den Kühlkörper übertragene Wärme auf einfache Weise abgeführt werden.

Eine andere Ausgestaltung sieht vor, dass die Kontaktbrücken des einer jeweiligen Phase zugeordneten elektromechanischen Schaltelements der Überbrückungseinheit einer mehrphasigen Schaltvorrichtung in einer gemeinsamen gedachten Linie der Erstreckungsrichtung angeordnet sind. Die jeweiligen Kontaktbrücken, die Teil des einer Phase zugeordneten elektromechanischen Schaltelements sind, liegen somit in Erstreckungsrichtung nebeneinander. Die elektromechanischen Schaltelemente jeweiliger Phasen sind voneinander getrennte Elemente, d.h. weisen keinen mechanischen Zusammenhang oder Verbindung auf.

Es ist weiterhin zweckmäßig, wenn eine Überbrückungseinheit des einer jeweiligen Phase zugeordneten elektromechanischen Schaltelements dazu ausgebildet ist, die Kontaktbrücken mit dem ersten und dem zweiten Anschlusselement zu verbinden, wobei die Überbrückungseinheit in einem Zwischenraum zwischen dem ersten und dem zweiten Anschlussteil geführt ist. Diese Ausgestaltung ermöglicht eine kompakte Realisierung des elektromechanischen Schaltelements einer jeweiligen Phase. Neben einem einfachen und robusten mechanischen Aufbau kann darüber hinaus ein kompaktes Schaltelement und damit eine kompakte Schaltvorrichtung bereitgestellt werden.

Insbesondere umfasst die Schaltvorrichtung ein Leistungsmodul und eine Überbrückungseinheit zur Schaltung von dreiphasigen Verbrauchern. In einer besonders zweckmäßigen Ausgestaltung ist die Schaltvorrichtung ein Sanftstarter für eine Arbeitsmaschine in Gestalt einer, insbesondere permanent erregten, Drehstrommaschine.

Die Erfindung wird nachfolgend näher anhand eines Ausführungsbeispiels in der Zeichnung erläutert. Es zeigen:
- Fig. 1: ein elektrisches Ersatzschaltbild einer Schaltvorrichtung für einen ein- oder mehrphasigen elektrischen Verbraucher;
- Fig. 2: eine schematische Darstellung auf eine aus dem Stand der Technik bekannte Schaltvorrichtung in einer Draufsicht;
- Fig. 3: eine erfindungsgemäße Schaltvorrichtung für einen dreiphasigen elektrischen Verbraucher in einer Draufsicht;
- Figs. 4 und 5: jeweils eine perspektivische Darstellung der in Fig. 3 gezeigten erfindungsgemäßen Schaltvorrichtung, wobei die in zwei unterschiedlichen Betriebszuständen auftretenden Strompfade illustriert sind;
- Fig. 6: eine perspektivische Darstellung einer erfindungsgemäßen Kombination eines Leistungsmoduls und einer Überbrückungseinheit für eine Phase;
- Fig. 7: eine schematische Darstellung eines Teils einer Übertragereinheit;
- Fig. 8: eine Komponente einer erfindungsgemäßen Überbrückungseinheit in einer perspektivischen Darstellung; und
- Fig. 9: eine perspektivische Darstellung einer Kombination von Leistungsmodul und Überbrückungseinheit mit einem Lüfterelement.

In den nachfolgend beschriebenen Figuren bezeichnen gleiche Bezugszeichen gleiche Elemente.

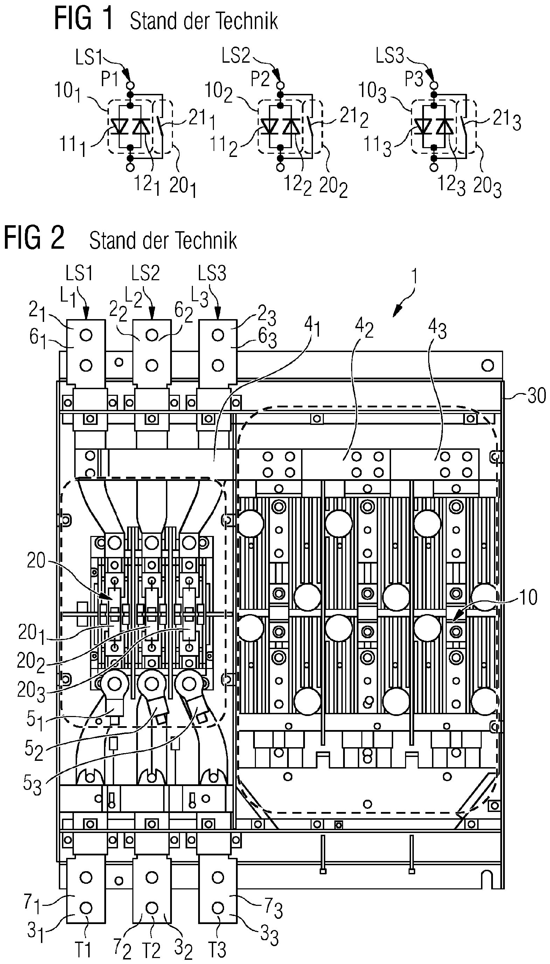

Fig. 1 zeigt eine schematische Darstellung eines Ersatzschaltbilds einer Schaltvorrichtung für einen dreiphasigen elektrischen Verbraucher. Die Schaltvorrichtung wird nachfolgend anhand eines Sanftstarters beschrieben, wobei dies jedoch nicht als beschränkend zu betrachten ist. Der elektrische Verbraucher stellt z.B. eine Arbeitsmaschine, insbesondere eine permanent erregte Drehstrommaschine dar. In einem jeweiligen Leitungsstrang LS1, LS2, LS3 jeder der Phasen P1, P2, P3 ist ein Schaltmodul angeordnet. Jedes Schaltmodul umfasst ein Leistungsmodul 10₁, 10₂ bzw. 10₃ und eine Überbrückungseinheit 20₁, 20₂ bzw. 20₃. Der in den Figuren einem Bezugszeichen nachgeordneter Index "1", "2" oder "3" bezeichnet dabei das jeweilige Element der Phase P1, P2 oder P3.

In einem jeweiligen Schaltmodul umfasst das Leistungsmodul 10₁, 10₂, 10₃ zwei antiparallel verschaltete steuerbare Halbleiterschaltelemente 11₁ und 12₁, 11₂ und 12₂ sowie 11₃ und 12₃. Parallel zu den steuerbaren Halbleiterschaltelementen 11₁ und 12₁, 11₂ und 12₂ sowie 11₃ und 12₃ ist pro Phase ein steuerbares elektromechanisches Schaltelement 21₁, 21₂ bzw. 21₃ vorgesehen, das Bestandteil der Überbrückungseinheit 20₁, 20₂ bzw. 20₃ ist. Die Überbrückungseinheit 20₁, 20₂ bzw. 20₃, die auch als Bypass bezeichnet wird, umfasst als steuerbares elektromechanisches Schaltelement in der Regel ein Schütz oder Relais. Die Überbrückungseinheit 20₁, 20₂ bzw. 20₃ dient dazu, nach dem Starten der Arbeitsmaschine durch Ansteuerung der Schaltelemente des Leistungsmoduls 10₁, 10₂, 10₃, die Verlustleistung des Schaltmoduls beim Nennbetriebspunkt der Arbeitsmaschine möglichst gering zu halten. Hierzu werden die steuerbaren elektromechanischen Schaltelemente 21₁, 21₂ bzw. 21₃ der Überbrückungsmodule 20 nach dem Erreichen des Nennbetriebspunkts der Arbeitsmaschine leitend geschaltet, wodurch die steuerbaren Halbleiterschaltelemente 11₁ und 12₁, 11₂ und 12₂ sowie 11₃ und 12₃ der Leistungsmodule 10₁, 10₂, 10₃ überbrückt sind. Der in Verbindung mit Fig. 1 beschriebene Aufbau des Schaltmoduls, das in allen drei Phasen identisch aufgebaut ist, entspricht der prinzipiellen elektrischen Verschaltung eines Sanftstarters.

Fig. 2 zeigt eine Draufsicht auf einen aus dem Stand der Technik bekannten Sanftstarter als Schaltvorrichtung für einen dreiphasigen Verbraucher.

Das mit dem Bezugszeichen 10 als Ganzes gekennzeichnete Leistungsmodul umfasst hierbei die in Fig. 1 dargestellten Leistungsmodule 10₁, 10₂ und 10₃ mit den jeweils zwei antiparallel geschalteten steuerbaren Halbleiterschaltelementen 11₁ und 12₁, 11₂ und 12₂ sowie 11₃ und 12₃ (nicht gesondert gekennzeichnet). Das Leistungsmodul 10, das in der gezeigten beispielhaften Bauform die Gesamtheit der steuerbaren Halbleiterschaltelemente für die drei Phasen P1, P2, P3 vereinigt, kann in einem eigenständigen Gehäuse vorgesehen sein.

Die Schaltvorrichtung 1 umfasst darüber hinaus die mit dem Bezugszeichen 20 als Ganzes gekennzeichnete Überbrückungseinheit, die die in der schematischen Darstellung der Fig. 1 gezeigten Überbrückungseinheiten 20₁, 20₂ und 20₃ mit den jeweiligen steuerbaren elektromechanischen Schaltelementen 21₁, 21₂ und 21₃ umfasst. Die Überbrückungseinheit 20 kann in einem eigenständigen Gehäuse realisiert sein.

In der in Fig. 2 dargestellten Ausgestaltungsvariante sind das Leistungsmodul 10 und die Überbrückungseinheit 20 exemplarisch in einem gemeinsamen Gehäuse 30 in Breitenrichtung nebeneinander (d.h. in der Blattebene von links nach rechts) angeordnet.

Oberhalb und unterhalb der Überbrückungseinheit 20 (d.h. in der Blattebene oberhalb und unterhalb) führen Anschlussschienen 2₁, 2₂ und 2₃ sowie 3₁, 3₂ und 3₃ an das heran bzw. in das Gehäuse 30 hinein. Für jede Phase P1, P2, P3 ist dabei eine jeweilige eingangsseitige Anschlussschiene 2₁, 2₂, 2₃ sowie eine ausgangsseitige Anschlussschiene 3₁, 3₂, 3₃ vorgesehen. An Endabschnitten 6₁, 6₂, 6₃ der eingangsseitigen Anschlussschiene 2₁, 2₂, 2₃ (in Blattebene oben) erfolgt eine Verbindung mit einer Netzphase L1, L2 bzw. L3. An Endabschnitten 7₁, 7₂, 7₃ der ausgangsseitigen Anschlussschienen 3₁, 3₂, 3₃ (in Blattebene unten) erfolgt eine elektrische Verbindung mit einer Anschlussphase T1, T2 und T3 des hier nicht dargestellten elektrischen Verbrauchers, d.h. der Arbeitsmaschine.

Zur Realisierung der Parallelschaltung jeweiliger steuerbarer elektromechanischer Schaltelemente 21₁, 21₂, 21₃ mit den steuerbaren Halbleiterschaltelementen 11₁ und 12₁ der Phase P1, 11₂ und 12₂ der Phase P2 sowie 11₃ und 12₃ der Phase P3 sind Verbindungsschienen 4₁, 4₂, 4₃ sowie Verbindungskabel 5₁, 5₂, 5₃ vorgesehen. Die auf der Eingangsseite vorgesehenen Verbindungsschienen 4₁, 4₂, 4₃ liegen dabei in der dargestellten Draufsicht übereinander, d.h. weisen untereinander keinerlei elektrische Verbindung auf. Gegebenenfalls kann ein Isolationsmaterial in den Abschnitten, in denen zwei Verbindungsschienen übereinander angeordnet sind, vorgesehen sein. Die ausgangsseitigen Anschlussschienen 3₁, 3₂, 3₃ sind in diesem Ausführungsbeispiel über Verbindungskabel 5₁, 5₂, 5₃ und jeweilige endseitige Kabelschuhe miteinander verbunden. Dem Fachmann ist klar, dass diese Verschaltung lediglich beispielhaft ist und ausschließlich Verbindungsschienen oder Verbindungskabel zum Einsatz kommen könnten.

Es ist ohne weiteres ersichtlich, dass die Verwendung der als separate Einheiten vorliegenden Leistungsmoduls 10 und Überbrückungseinheit 20 sowie notwendige Verdrahtungen zur Ausbildung jeweiliger Leitungsstränge LS1, LS2, LS3 für die drei Phasen P1, P2, P3 mit einem hohen Aufwand verbunden ist. Hieraus resultiert auch ein unerwünschter, nicht kompakter Aufbau, wobei insbesondere ein großer Bauraum in der Breite (d.h. in der Blattebene von links nach rechts) erforderlich ist.

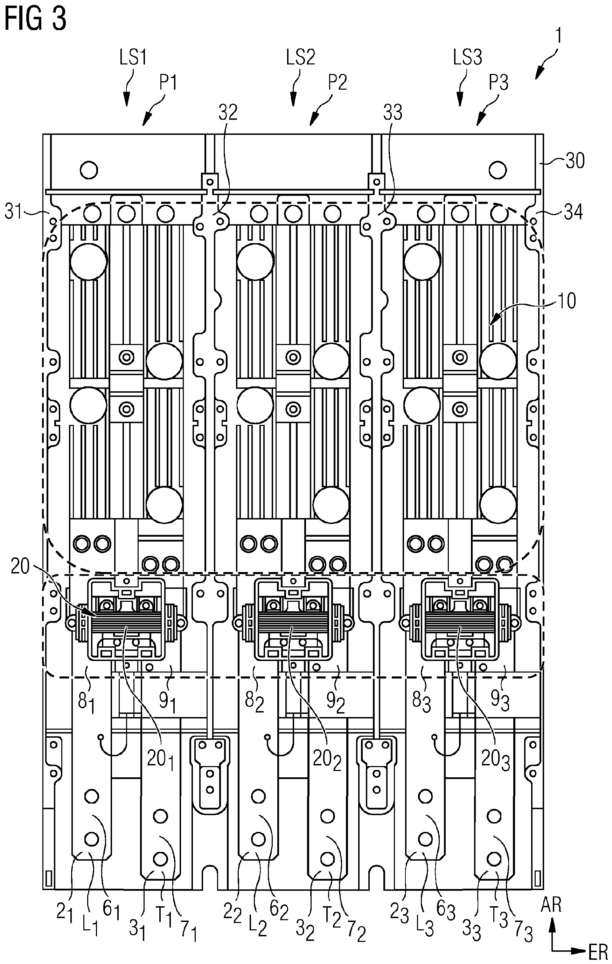

Die nachfolgend in den Fig. 3 bis 5 dargestellte erfindungsgemäße Schaltvorrichtung ist demgegenüber mit größerer Kompaktheit und geringerem Verdrahtungsaufwand bereitgestellt. Fig. 3 zeigt hierbei eine Draufsicht auf eine erfindungsgemäße Schaltvorrichtung 1 mit einem Leistungsmodul 10 sowie einer Überbrückungseinheit 20 für einen dreiphasigen elektrischen Verbraucher (nicht dargestellt).

Der technische Aufbau des Leistungsmoduls 10 mit seinen jeweiligen Leistungsmodulen 10₁, 10₂ und 10₃ für die Phasen P1, P2 und P3 unterscheidet sich nicht von dem in Fig. 2 gezeigten und beschriebenen Sanftstarter. Im Unterschied zu der aus dem Stand der Technik bekannten Variante werden jedoch die ein- und ausgangsseitigen Anschlussschienen 2₁ und 3₁ der Phase P1, 2₂ und 3₂ der Phase P2 und 2₃ und 3₃ der Phase P3 an einer Seite des Leistungsmoduls 10 derart benachbart nebeneinander angeordnet, wodurch die Anschlussschienen 2₁ und 3₁ der Phase P1, die Anschlussschienen 2₂ und 3₂ der Phase P2 und die Anschlussschienen 2₃ und 3₃ der Phase P3 in einer Erstreckungsrichtung ER nebeneinander angeordnet sind. Die Erstreckungsrichtung ER entspricht der Breitenrichtung und verläuft in der Blattebene von links nach rechts. Im vorliegenden Ausführungsbeispiel sind die Anschlussschienen 2₁, 3₁, 2₂, 3₂, 2₃, 3₃ an der Unterseite der Schaltvorrichtung 1 angeordnet.

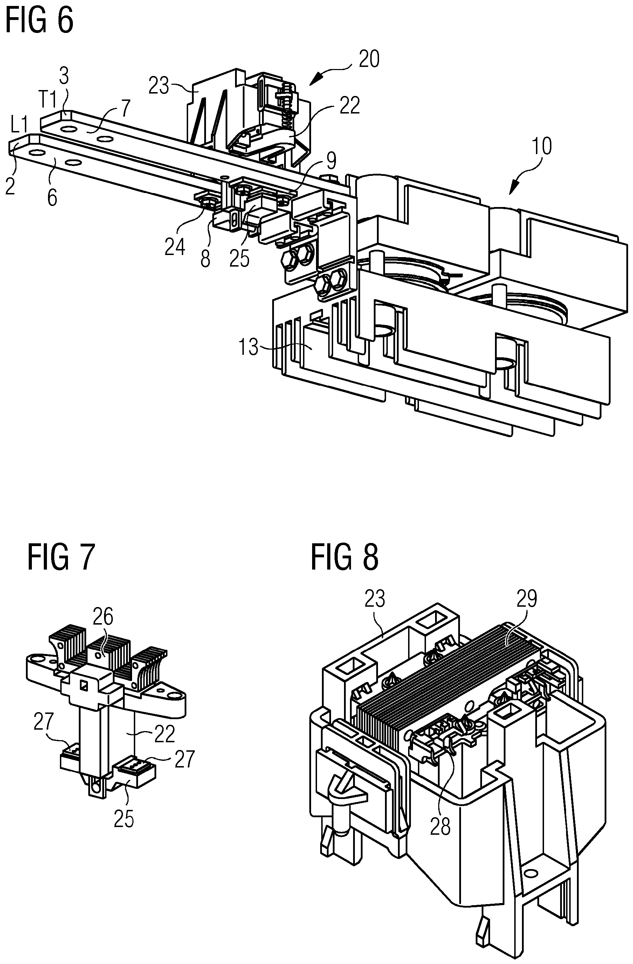

Die Anschlussschienen 2₁, 3₁, 2₂, 3₂, 2₃, 3₃ verlaufen dabei quer zu der Erstreckungsrichtung ER in einer sog. Anordnungsrichtung AR (in der Blattebene von oben nach unten). Benachbart zu dem Leistungsmodul 10 weisen die Anschlussschienen 2₁, 3₁, 2₂, 3₂, 2₃, 3₃ jeweilige erste und zweite Anschlussteile 8₁, 9₁, 8₂, 9₂, 8₃, 9₃ in Gestalt von flächigen Abschnitten der Anschlussschienen auf. Eine jeweilige Kontaktbrücke 25 (Figuren 6 und 7) der Überbrückungseinheiten 20₁, 20₂ und 20₃ des einer jeweiligen Phase P1, P2, P3 zugeordneten elektromechanischen Schaltelements verläuft dabei in der Erstreckungsrichtung ER, um im eingeschalteten Zustand das erste und das zweite Anschlussteil 8₁, 9₁ der Phase P1 bzw. 8₂, 9₂ der Phase P2 bzw. 8₃, 9₃ der Phase P3 elektrisch miteinander zu verbinden.

Dies bedeutet, dass die pro Phase vorgesehenen Überbrückungseinheiten 20₁, 20₂, 20₃ der gesamten Überbrückungseinheit 20 in Draufsicht unterhalb des Leistungsmoduls 10 angeordnet sind, so dass die Anschlussschienen 2₁, 3₁, 2₂, 3₂, 2₃, 3₃ quer zur Erstreckungsrichtung ER in der Anordnungsrichtung AR parallel nach unten verlaufen. Infolgedessen kommen die Endabschnitte 6₁ und 7₁ der Anschlussschienen 2₁, 3₁, die Endabschnitte 6₂ und 7₂ der Anschlussschienen 2₂, 3₂ sowie die Endabschnitte 6₃ und 7₃ der Anschlussschienen 2₃, 3₃ benachbart nebeneinander zum Liegen. Dass die von dem Leistungsmodul 10 abgewandten Enden jeweiliger eingangsseitiger Anschlussschienen 2₁, 2₂ und 2₃ eine geringe Länge als die der ausgangsseitigen Anschlussschienen 3₁, 3₂ und 3₃ aufweisen, ist lediglich eine optionale Ausgestaltungsform.

Die Leistungsmodule 10₁, 10₂, 10₃ und die zugeordneten Überbrückungseinheiten 20₁, 20₂, 20₃ einer jeweiligen Phase P1, P2, P3 sind damit in der Anordnungsrichtung AR übereinander angeordnet, wodurch sich eine geringe Breite ergibt. Da für den Anschluss der Schaltvorrichtung 1 oberhalb des Leistungsmoduls 10 kein Platz, z.B. zur Herstellung einer elektrischen Verbindung, benötigt wird, wird im Vergleich zu der herkömmlichen Schaltvorrichtung 1 auch in Höhenrichtung weniger Platz benötigt.

Das Leistungsmodul 10 und die Überbrückungseinheit 20 sind im hier gezeigten Ausführungsbeispiel in einem gemeinsamen Gehäuse 30 angeordnet. Von diesem gemeinsamen Gehäuse 30 sind auch die Endabschnitte 6₁, 6₂, 6₃ und 7₁, 7₂, 7₃ zumindest von einer Seite umgeben.

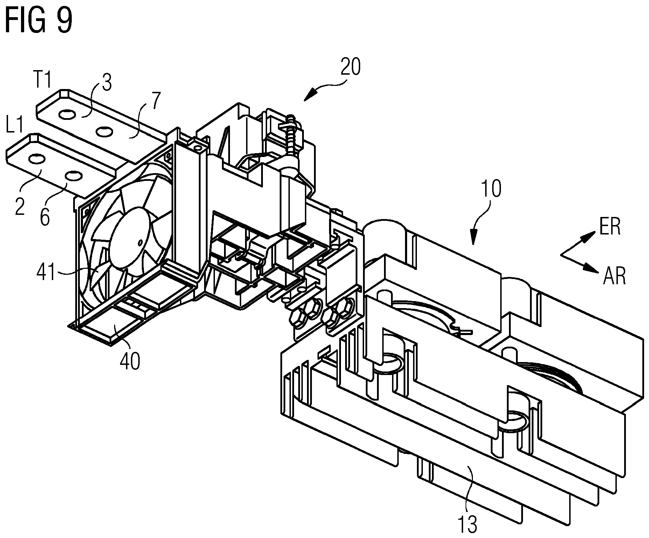

Die Leistungsmodule 10₁, 10₂, 10₃ und die Überbrückungseinheiten 20₁, 20₂, 20₃ einer jeweiligen Phase P1, P2, P3 sind seitlich von in der Anordnungsrichtung AR verlaufenden Trennwänden 31, 32, 33, 34 begrenzt. Hierdurch ist eine elektrische Isolation zwischen den Komponenten unterschiedlicher Phasen sichergestellt. Gleichzeitig kann auf einfache Weise eine Kühlung der elektrischen Komponenten erfolgen wie in der perspektivischen Darstellung der Komponenten einer Phase in Fig. 9 dargestellt ist. Grundsätzlich ist pro Phase P1, P2, P3 ein Lüfterelement 40 vorgesehen, wobei dieses in Fig. 9 an den zu der betreffenden Phase gehörigen Anschlussschienen 2, 3 mechanisch befestigt ist. Das Lüfterelement 40 und die Überbrückungseinheit 20 sind dabei auf gegenüberliegenden Seiten der zu der Phase gehörenden Anschlussschiene 2, 3 angeordnet. Dadurch kann insbesondere ein unterhalb des Leistungsmoduls 10 angeordneter Kühlkörper 13, der in einem von dem Lüfterelement 40 erzeugten Luftstrom in der Anordnungsrichtung liegt, gut gekühlt werden. Damit ist insbesondere eine effektive Abfuhr der von den steuerbaren Halbleiterschaltelementen des Leistungsmoduls 10 erzeugten Wärme möglich.

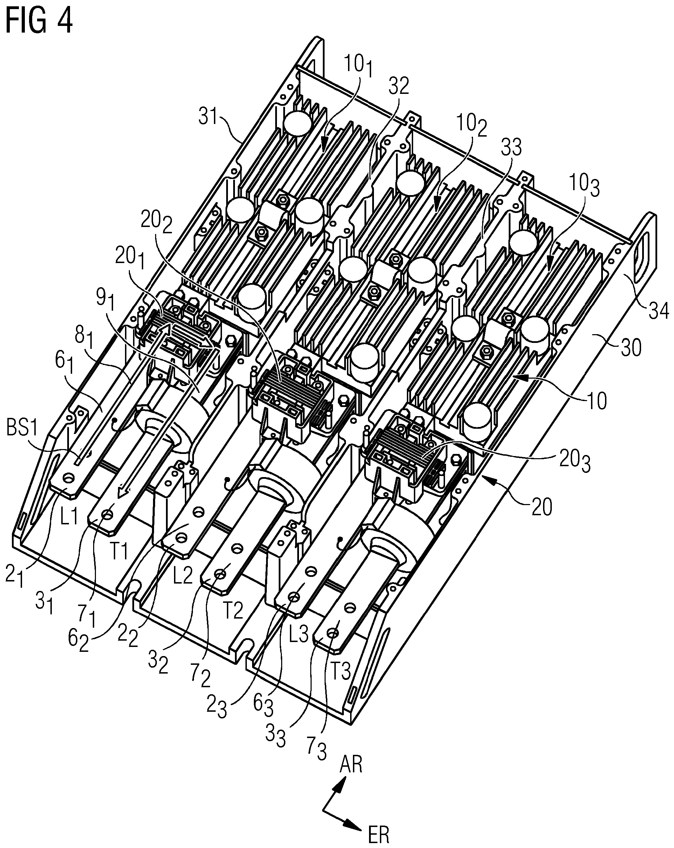

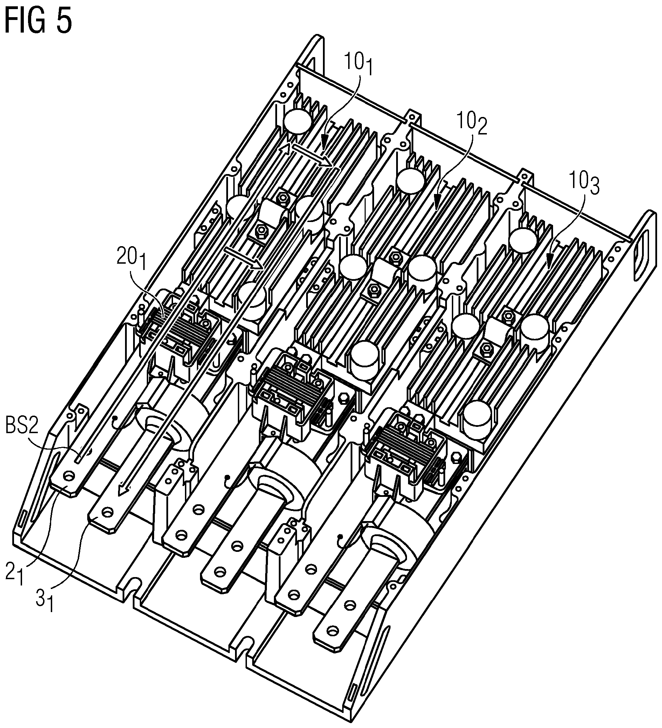

Die Figuren 4 und 5 zeigen perspektivische Darstellungen der in Fig. 3 gezeigten Schaltvorrichtung (Sanftstarter) von oben. In Fig. 4 ist dabei für die Phase P1 mit BS1 der über das Überbrückungsmodul 20₁ gezeigte Stromverlauf nach dem Erreichen des Nennbetriebspunkts der an die Schaltvorrichtung angeschlossenen Arbeitsmaschine gezeigt. Der Strom fließt über die eingangsseitige Anschlussschiene 2₁, die geschlossene Schaltbrücke, die das erste Anschlussteil 8₁ elektrisch mit dem zweiten Anschlussteil 9₁ der ausgangsseitigen Schiene 3 verbindet und die Anschlussschiene 3₁ zurück in Richtung des Endabschnitts 7₁.

Fig. 5 zeigt den Stromfluss während des Anlaufens der Arbeitsmaschine für die Phase P1, wobei der Stromfluss mit BS2 gekennzeichnet ist. Dabei ist die Kontaktbrücke nicht mit dem ersten und dem zweiten Anschlussteil 8₁ der Anschlussschiene 2₁ und 9₁ der Anschlussschiene 3₁ verbunden, weswegen der Strom über das in Anordnungsrichtung AR zugeordnete Leistungsmodul 10₁ und zurück über die ausgangsseitige Anschlussschiene 3₁ fließt. In der in Fig. 5 gezeigten Betriebssituation ist somit das steuerbare elektromechanische Schaltelement 21₁ der Überbrückungseinheit 20₁ geöffnet.

Fig. 6 zeigt eine perspektivische Darstellung eines Teils der Schaltvorrichtung 1 für eine Phase. Da der Aufbau für die drei Phasen P1, P2, P3 identisch ist, sind in Fig. 6, 7 und 8 die jeweiligen Indizes der Bezugszeichen weggelassen.

Wie erwähnt, ist unterhalb des Leistungsmoduls 10 der Kühlkörper 13, z.B. aus einem Metall, insbesondere Aluminium, angeordnet. Die Verbindung zwischen Leistungsmodul 10 und Kühlkörper 13 erfolgt gut wärmeleitend, z.B. über eine Verschraubung. Gut ersichtlich ist, sind die eingangsseitige Anschlussschiene 2 und die ausgangsseitige Ausgangsschiene 3 von einer Seite her an das Leistungsmodul 10 herangeführt sind. Benachbart zu dem Leistungsmodul 10 ist auf der Oberseite der Anschlussschiene 2, 3 das Überbrückungsmodul 20 angeordnet, von dem Teile in den Fig. 7 und 8 dargestellt sind.

Fig. 8 zeigt dabei den auf der Oberseite der Anschlussschienen 2 und 3 angeordneten Spulenhalter 23, eine Magnetspule 28 sowie ein Joch 29, die in dem Spulenhalter 23 aufgenommen sind. In einem zwischen den Anschlussschienen 2 und 3 gebildeten Zwischenraum ist ein in dem Spulenhalter 23 aufgenommener Kontaktträger 22 (Fig. 7) als Übertragereinheit durchgeführt, an dessen unteren Ende die Kontaktbrücke 25 mit an gegenüberliegenden Enden angeordneten Kontakten 27 vorgesehen ist. Die Kontakte 27 kommen dabei, wie oben beschrieben, mit dem ersten Anschlussteil 8 der Anschlussschiene 2 und dem zweiten Anschlussteil 9 der Anschlussschiene 3 in Kontakt, wenn die Überbrückungseinheit 20 durch ein entsprechendes Ansteuersignal eingeschaltet ist. Das Bezugszeichen 26 bezeichnet einen Anker, wobei im Inneren des nach unten verlaufenden Kontaktträgers 22 in einer dem Fachmann bekannten Weise ein Federbügel sowie eine Kontaktfeder angeordnet sind, um eine Bewegung der Kontaktbrücke nach oben und unten und damit zu den Anschlussschienen 2, 3 hin oder von diesen weg zu ermöglichen.

Bei entsprechender Ansteuerung durch eine in den Figuren nicht gezeigte Steuerung fließt durch die Magnetspule ein Strom 28, wodurch der Anker 26 nach oben bewegt wird. Aufgrund der mechanischen Kopplung wird die Kontaktbrücke 25 mit den Kontakten 27 nach oben an die Anschlussschienen 2, 3 gedrückt. Sobald der Strom durch die Magnetspule 28 ausgeschaltet ist, sorgt die im Inneren des Kontaktträgers verlaufende Feder dafür, dass die Kontakte 27 der Kontaktbrücke 25 von den Anschlussteilen 8, 9 der Anschlussschienen 2, 3 weggedrückt werden.

Der Kontaktträger 22 dient somit zur Fixierung der Kontaktbrücke 25 der Kontaktfeder der Federbügel des Ankers und dergleichen. Der Spulenhalter 23 wird benötigt, um die Magnetspule 28 um das Joch 29 in Position zu halten. Durch diesen kompakten Aufbau kann die Verlustwärme, die durch die elektrischen Widerstände der Anschlussschienen und Kontaktübergänge entsteht, reduziert werden.

Im Ergebnis kann eine als Sanftstarter ausgebildete Schaltvorrichtung äußerst kompakt gebaut werden. Eine Verbindung zu einer Überbrückungseinheit kann entfallen. Die Reduzierung der Stromwege und die Reduzierung der Kontaktstellen haben einen positiven Effekt auf die Verlustwärme und die Robustheit des Geräts.

Durch den Einbau der Überbrückungskomponenten in den Lüftungsstrang der Leistungsmodule kann auf eine zusätzliche Kühlung der Bypasskontakte durch eine Zwangsbelüftung verzichtet werden. Auch hierdurch ergibt sich ein positiver Einfluss auf die Herstellkosten der Schaltvorrichtung.

## Patentansprüche

1. Schaltvorrichtung für einen ein- oder mehrphasigen elektrischen Verbraucher, umfassend
- eine der Anzahl der Phasen (P1,P2,P3) entsprechende Anzahl an Leitungssträngen (LS1,LS2,LS3), wobei jeder Leitungsstrang (LS1,LS2,LS3) ein als Eingang dienendes erstes Anschlussteil (8) zur Verbindung mit einer Netzphase (L1,L2,L3) und ein als Ausgang dienendes zweites Anschlussteil (9) zur Verbindung mit einer Anschlussphase (T1,T2,T3) des elektrischen Verbrauchers umfasst;
- ein Leistungsmodul (10), das pro Phase (P1,P2,P3) zumindest ein steuerbares Halbleiterschaltelement (11₁, 11₂, 11₃, 12₁, 12₂, 12₃) umfasst, wobei das zumindest eine steuerbare Halbleiterschaltelement (11₁, 11₂, 11₃, 12₁, 12₂, 12₃) zwischen dem ersten und dem zweiten Anschlussteil (8, 9) verschaltet ist;
- eine Überbrückungseinheit (20), die pro Phase (P1,P2,P3) ein steuerbares elektromechanisches Schaltelement (21₁, 21₂, 21₃) mit geringem Durchlasswiderstand umfasst, wobei das steuerbare elektromechanische Schaltelement (21₁, 21₂, 21₃), parallel zu dem zumindest einen steuerbaren Halbleiterschaltelement (11₁, 11₂, 11₃, 12₁, 12₂, 12₃) dieser Phase (P1,P2,P3), zwischen dem ersten und dem zweiten Anschlussteil (8, 9) verschaltet ist;
wobei
- das erste und das zweite Anschlussteil (8, 9) einer jeweiligen Phase (P1,P2,P3) an einer Seite des Leistungsmoduls (10) in räumlicher Nähe in einer Erstreckungsrichtung (ER) benachbart nebeneinander angeordnet sind,
- eine Kontaktbrücke (25) des einer jeweiligen Phase (P1,P2,P3) zugeordneten elektromechanischen Schaltelements (21₁, 21₂, 21₃) der Überbrückungseinheit (20) in der Erstreckungsrichtung (ER) verläuft, um im eingeschalteten Zustand das erste und das zweite Anschlussteil (8, 9) elektrisch zu verbinden,
**dadurch gekennzeichnet,**
**dass** die Schaltvorrichtung pro Phase (P1,P2,P3) ein Lüfterelement (40) umfasst, welches an zu einer Phase (P1,P2,P3) gehörenden Anschlussschienen (2, 3) mechanisch befestigt ist.

2. Schaltvorrichtung nach Anspruch 1, **dadurch gekennzeichnet, dass** das Leistungsmodul (10) und die Überbrückungseinheit (20) in einem gemeinsamen Gehäuse (30) angeordnet sind.

3. Schaltvorrichtung nach Anspruch 1 oder 2, **dadurch gekennzeichnet, dass** das Leistungsmodul (10) und die Überbrückungseinheit (20) einer jeweiligen Phase (P1,P2,P3) hintereinander in einer Anordnungsrichtung (AR) angeordnet sind, die quer zu der Erstreckungsrichtung (ER) verläuft.

4. Schaltvorrichtung nach Anspruch 3, **dadurch gekennzeichnet, dass** das Leistungsmodul (10) und die Überbrückungseinheit (20) einer jeweiligen Phase (P1,P2,P3) seitlich von in der Anordnungsrichtung (AR) verlaufenden Trennwänden (31,32,33,34) begrenzt sind.

5. Schaltvorrichtung nach einem der vorhergehenden Ansprüche, **dadurch gekennzeichnet, dass** das erste und das zweite Anschlussteil (8, 9) flächige Abschnitte von Anschlussschienen (2,3) sind, deren Enden flächige Endabschnitte (6,7) zur Verbindung mit Anschlusselementen der Netzphase (L1,L2,L3) bzw. der Anschlussphase (T1,T2,T3) des Verbrauchers umfassen.

6. Schaltvorrichtung nach Anspruch 1, **dadurch gekennzeichnet, dass** das Lüfterelement (40) und die Überbrückungseinheit (20) auf gegenüberliegenden Seiten der, zu einer Phase (P1,P2,P3) gehörenden, Anschlussschienen (2,3) angeordnet sind.

7. Schaltvorrichtung nach einem der vorhergehenden Ansprüche, **dadurch gekennzeichnet, dass** ein von dem Lüfterelement (40) erzeugbarer Luftstrom in der Anordnungsrichtung (AR) einen mit dem Leistungsmodul (10) wärmeleitend verbundenen Kühlkörper (13) anströmt.

8. Schaltvorrichtung nach einem der vorhergehenden Ansprüche, **dadurch gekennzeichnet, dass** die Kontaktbrücken (25) des einer jeweiligen Phase (P1,P2,P3) zugeordneten elektromechanischen Schaltelements (21₁, 21₂, 21₃) der Überbrückungseinheit (20) einer mehrphasigen Schaltvorrichtung in einer gemeinsamen gedachten Linie der Erstreckungsrichtung (ER) angeordnet sind.

9. Schaltvorrichtung nach einem der vorhergehenden Ansprüche, **dadurch gekennzeichnet, dass** eine Übertragereinheit (22, 26) des einer jeweiligen Phase (P1,P2,P3) zugeordneten elektromechanischen Schaltelements (21₁, 21₂, 21₃) dazu ausgebildet ist, die Kontaktbrücke (25) mit dem ersten und dem zweiten Anschlussteil (8, 9) zu verbinden, wobei die Übertragereinheit in einem Zwischenraum zwischen dem ersten und dem zweiten Anschlussteil geführt ist.

10. Schaltvorrichtung nach einem der vorhergehenden Ansprüche, **dadurch gekennzeichnet, dass** diese ein Leistungsmodul (10) und eine Überbrückungseinheit (20) zur Schaltung von drei Phasen (P1,P2,P3) umfasst.

11. Schaltvorrichtung nach einem der vorhergehenden Ansprüche, **dadurch gekennzeichnet, dass** diese ein Sanftstarter für eine, insbesondere permanenterregte, Drehstrommaschine, ist.

## Claims

1. Switching device for a single-phase or multiphase electrical consumer, comprising
- a number of line sections (LS1, LS2, LS3) corresponding to the number of phases (P1, P2, P3), wherein each line section (LS1, LS2, LS3) comprises a first connection part (8), serving as input, for connection to a grid phase (L1, L2, L3) and a second connection part (9), serving as output, for connection to a connection phase (T1, T2, T3) of the electrical consumer;
- a power module (10) that comprises at least one controllable semiconductor switching element (11₁, 11₂, 11₃, 12₁, 12₂, 12₃) per phase (P1, P2, P3), wherein the at least one controllable semiconductor switching element (11₁, 11₂, 11₃, 12₁, 12₂, 12₃) is wired between the first and the second connection part (8, 9) ;
- a bypass unit (20) that comprises one controllable electromechanical switching element (21₁, 21₂, 21₃) with a low on-resistance per phase (P1, P2, P3), wherein the controllable electromechanical switching element (21₁, 21₂, 21₃) is wired, in parallel with the at least one controllable semiconductor switching element (11₁, 11₂, 11₃, 12₁, 12₂, 12₃) of this phase (P1, P2, P3), between the first and the second connection part (8, 9);
wherein
- the first and the second connection part (8, 9) of a respective phase (P1, P2, P3) are arranged adjacently next to one another on one side of the power module (10) in spatial proximity in a direction of extent (ER),
- a contact bridge (25) of the electromechanical switching element (21₁, 21₂, 21₃), assigned to a respective phase (P1, P2, P3), of the bypass unit (20) runs in the direction of extent (ER) in order to electrically connect the first and the second connection part (8, 9) in the switched-on state,
**characterized in that**
the switching device comprises one fan element (40) per phase (P1, P2, P3), which fan element is mechanically attached to connection rails (2, 3) belonging to a phase (P1, P2, P3).

2. Switching device according to Claim 1, **characterized in that** the power module (10) and the bypass unit (20) are arranged in a common housing (30).

3. Switching device according to Claim 1 or 2, **characterized in that** the power module (10) and the bypass unit (20) of a respective phase (P1, P2, P3) are arranged behind one another in an arrangement direction (AR) that runs transverse to the direction of extent (ER).

4. Switching device according to Claim 3, **characterized in that** the power module (10) and the bypass unit (20) of a respective phase (P1, P2, P3) are bounded laterally by partition walls (31, 32, 33, 34) running in the arrangement direction (AR).

5. Switching device according to one of the preceding claims, **characterized in that** the first and the second connection part (8, 9) are flat sections of connection rails (2, 3) whose ends comprise flat end sections (6, 7) for connection to connection elements of the grid phase (L1, L2, L3) or the connection phase (T1, T2, T3) of the consumer.

6. Switching device according to Claim 1, **characterized in that** the fan element (40) and the bypass unit (20) are arranged on opposing sides of the connection rails (2, 3) belonging to a phase (P1, P2, P3).

7. Switching device according to one of the preceding claims, **characterized in that** an airflow able to be generated by the fan element (40) impinges on a heat sink (13) thermally conductively connected to the power module (10) in the arrangement direction (AR).

8. Switching device according to one of the preceding claims, **characterized in that** the contact bridges (25) of the electromechanical switching element (21₁, 21₂, 21₃), assigned to a respective phase (P1, P2, P3), of the bypass unit (20) of a multiphase switching device are arranged in a common imaginary line of the direction of extent (ER).

9. Switching device according to one of the preceding claims, **characterized in that** a transformer unit (22, 26) of the electromechanical switching element (21₁, 21₂, 21₃) assigned to a respective phase (P1, P2, P3) is designed to connect the contact bridge (25) to the first and the second connection part (8, 9), wherein the transformer unit is routed in an intermediate space between the first and the second connection part.

10. Switching device according to one of the preceding claims, **characterized in that** it comprises a power module (10) and a bypass unit (20) in order to switch three phases (P1, P2, P3).

11. Switching device according to one of the preceding claims, **characterized in that** it is a soft starter for an in particular permanently excited three-phase current machine.

## Revendications

1. Dispositif de coupure pour un consommateur électrique monophasé ou polyphasé, comprenant
- un nombre, correspondant au nombre des phases (P1, P2, P3), de branches (LS1, LS2, LS3) de conduction, dans lequel chaque branche (LS1, LS2, LS3) de conduction comprend une première partie (8) de connexion servant d'entrée, pour la connexion a une phase (L1, L2, L3) du réseau, et une deuxième partie (9) de connexion servant de sortie, pour la connexion à une phase (T1, T2, T3) de connexion du consommateur électrique ;
- un module (10) de puissance, qui comprend, par phase (P1, P2, P3) au moins un élément (11₁, 11₂, 11₃, 12₁, 12₂, 12₃) de coupure à semiconducteur pouvant être commandé, dans lequel le au moins un élément (11₁, 11₂, 11₃, 12₁, 12₂, 12₃) de coupure à semiconducteur pouvant être commandé est monté entre la première et la deuxième parties (8, 9) de connexion ;
- une unité (20) de shuntage, qui comprend, par phase (P1, P2, P3), un élément (21₁, 21₂, 21₃) électromécanique de coupure pouvant être commandé, ayant une petite résistance directe, dans lequel l'élément (21₁, 21₂, 21₃) électromécanique de coupure pouvant être commandé est monté en parallèle avec le au moins un élément (11₁, 11₂, 11₃, 12₁, 12₂, 12₃) de coupure à semiconducteur pouvant être commandé de cette phase (P1, P2, P3) entre la première et la deuxième partie (8, 9) de connexion ;
dans lequel
- la première et la deuxième parties (8, 9) de connexion d'une phase (P1, P2, P3) respective sont montées l'une à côté de l'autre à proximité dans une direction (ER), dans laquelle elles s'étendent, à proximité dans l'espace d'un côté du module (10) de puissance,
- un pont (25) de contact de l'élément (21₁, 21₂, 21₃) électromécanique de coupure, associé à une phase (P1, P2, P3) respective de l'unité (20) de shuntage, s'étend dans la direction (ER) d'étendue, pour connecter électriquement dans l'état fermé la première et la deuxième partie (8, 9) de connexion,
**caractérisé**
**en ce que** le dispositif de coupure comprend, par phase (P1, P2, P3) un élément (40) de ventilateur, qui est fixé mécaniquement à des rails (2, 3) de connexion appartenant à une phase (P1, P2, P3) .

2. Dispositif de coupure suivant la revendication 1, **caractérisé en ce que** le module (10) de puissance et l'unité (20) de shuntage sont disposés dans un boîtier (30) commun.

3. Dispositif de coupure suivant la revendication 1 ou 2, **caractérisé en ce que** le module (10) de puissance et l'unité (20) de shuntage d'une phase (P1, P2, P3) respective sont disposés l'un derrière l'autre dans une direction (AR) de montage, qui s'étend transversalement à la direction (ER) d'étendue.

4. Dispositif de coupure suivant la revendication 3, **caractérisé en ce que** le module (10) de puissance et l'unité (20) de shuntage d'une phase (P1, P2, P3) respective sont limités latéralement par des cloisons (31, 32, 33, 34) s'étendant dans la direction (AR) de montage.

5. Dispositif de coupure suivant l'une des revendications précédentes, **caractérisé en ce que** la première et la deuxième parties (8, 9) de connexion sont des parties planes de rails (2, 3) de connexion, dont les extrémités comprennent des tronçons (6, 7) d'extrémités plans de connexion à des éléments de connexion des phases (L1, L2, L3) du réseau ou des phases (T1, T2, T3) de connexion.

6. Dispositif de coupure suivant la revendication 1, **caractérisé en ce que** l'élément (40) de ventilateur et l'unité (20) de shuntage sont disposés sur des côtés opposés des rails (2, 3) de connexion appartenant à une phase (P1, P2, P3).

7. Dispositif de coupure suivant l'une des revendications précédentes, **caractérisé en ce qu'**un courant d'air produit par l'élément (40) de ventilateur arrive dans la direction (AR) de montage sur un puits (13) de chaleur, relié d'une manière conductrice de la chaleur au module (10) de puissance.

8. Dispositif de coupure suivant l'une des revendications précédentes, **caractérisé en ce que** les ponts (25) de contact de l'élément (21₁, 21₂, 21₃) électromécanique de coupure, associé à une phase (P1, P2, P3) respective de l'unité (20) de shuntage d'un dispositif de coupure polyphasé sont disposés suivant une ligne imaginaire commune de la direction (ER) d'étendue.

9. Dispositif de coupure suivant l'une des revendications précédentes, **caractérisé en ce qu'**une unité (22, 26) de transmission de l'élément (21₁, 21₂, 21₃) électromécanique de coupure, associé à une phase (P1, P2, P3) respective, est constituée de manière à connecter le pont (25) de contact à la première et à la deuxième parties (8, 9) de connexion, l'unité de transmission passant dans un espace intermédiaire entre la première et la deuxième parties de connexion.

10. Dispositif de coupure suivant l'une des revendications précédentes, **caractérisé en ce que** celui-ci comprend un module (10) de puissance et une unité (20) de transmission pour la coupure de trois phases (P1, P2, P3).

11. Dispositif de coupure suivant l'une des revendications précédentes, **caractérisé en ce que** celui-ci est un démarreur doux d'une machine triphasée, notamment à excitation permanente.
